# EUROPEAN PATENT SPECIFICATION

(11) **EP 1 496 615 B1**
(45) Date of publication and mention of the grant of the patent: **03.05.2006**
(21) Application number: 03015706.9
(22) Date of filing: 09.07.2003
(51) Int. Cl.: H03J 5/00, H04N 5/50

(54) **Receiver and method for generating an individual station list**
Empfänger und Verfahren zur Erzeugung einer individuellen Senderliste
Récepteur et procédé de génération d'une liste d'émetteurs individuelle

(43) Date of publication of application: 12.01.2005
(73) Proprietor: MATSUSHITA ELECTRIC INDUSTRIAL CO., LTD., Kadoma-shi, Osaka 571-8501 (JP)
(72) Inventor: Bierwirth, Oliver, 37434 Rhumspringe (DE); Seydel, Christian, 37520 Osterode (DE)
(74) Representative: Lins, Edgar

(56) References cited:
- WO-A-03/036945
- DE-A- 4 417 634
- US-A- 5 323 240
- US-A1- 2003 115 589

## Description

The present invention is related to a method for generating an individual station list of a receiver for radio, television and/or data signals which individual station list comprises a ranking of stations according to personal preferences wherein the number or duration of selections of tuned stations are detected and evaluated for determining and/or changing the ranking of the stations within the station list.

The present invention is furthermore related to a receiver for radio, television and/or data signals transmitted from several transmitting stations, comprising a memory unit including a micro controller for storing said stations ranked according to user's preferences in a station list wherein the micro controller is arranged to receive signals corresponding to the number or duration of selections of tuned stations and to determine and/or change the ranking of the stations within the station list.

It is well known to use station lists which are ranked according to user's preference for correlating stations to selecting means of a control unit. The most preferred station is correlated to key number 1 the next preferred to key number 2 and so on. Consequently, it is important to select the nine most preferred stations which regularly only use the pressing of one key to be selected whereas less preferred stations require the pressing of two or even three keys.

Additionally, user may remember one-digit station numbers easier than higher station numbers requiring two or three digits.

It is well known to use an automatic station list generating by the producer of a television set like television receiver etc.. However, most television receivers offer the possibility to amend the ranking of the television stations in accordance with user's preferences. In this way an individual station list is generated by manual input and used for the correlation of the selecting means.

The station list is normally fixed for the respective receiver and represents the alleged preferences of one user to the time of the first set-up of the receiver and will in most cases not be amended later. Consequently, the station list does very often not represent the actual preferences of the user.

US 2003/0115589 A1 discloses a system wherein a list of favourite channels is produced by flagging normal channels as favourite channels. Said list is used as a means for establishing a separate mechanism wherein only stations included in the favourite channel lists may be selected. The generation of a station list for all tuneable stations is not influenced by said flagging.

A method and receiver as mentioned above are disclosed by DE 44 17 634 A1. The station list is constructed in accordance to an accumulated time during which the tuner has been tuned to a specific station or in accordance with a number with selections of a specific station during a predetermined observation period. The selection of channel is made by channel up/down keys.

It is therefore an object of the present invention to provide a method for generating improved station lists allowing the determination and amendment of the ranking of a specific station within said station list and to provide a receiver using the improved station list.

In accordance with the present invention the above object is achieved by a method of the above-mentioned kind which is characterized in that said individual station list is used for correlating selecting means of a control unit of said receiver to stations, thereby allowing the selection of a station by using a number in accordance with the ranking of the station within said station list and in that the number and duration of selections of tuned stations are detected and evaluated for determining and/or changing the ranking of the stations within the station list.

The ranking of the station list according to the present invention is consequently not fixed but may be amended in accordance with the number and duration of station selections. The user may therefore amend the station list in accordance with his use of the receiver.

In order to avoid wrong evaluations it is preferable to evaluate only those selections of a station after which the tuned station remained tuned for a predetermined minimum duration. Those stations which are only selected during so called zapping actions will be neglected.

The generation of the station list according to the present invention may be further improved by inputting an user identification to the receiver and by generation the station list specific to the identified user.

Consequently, different station lists may be generated by the receiver for different users.

The above-mentioned object is further achieved by a receiver of the above-mentioned kind which is characterised in that said micro controller is further adapted for correlating selecting means of a control unit of the receiver to stations in accordance with a number related to the ranking of the station within said station list, and said micro controller is arranged to receive signals corresponding to the number and duration of selections of tuned stations and to determine and/or change the ranking of the stations within the station list based on an evaluation of said received signals.

Said micro controller may be arranged to further receive user identification signals and to generate station lists individually for a specific user.

In accordance with the present invention the data representing the number and duration of selections of tuned stations will be collected. It is preferred that only upon a corresponding signal initiated by the user an amendment of the station list becomes effective so that any effective change of the station list will take place only upon a corresponding action of the user and will not surprise the user.

The receiver will be provided with a default station list stored in the memory unit before the individual station list, especially for a specific user, is built up. In a preferred embodiment of the present invention the default station list remains stored in the memory unit and the receiver is provided with a resetting means for resetting the receiver to the default station list upon request of the user.

## Claims

1. Method for generating an individual station list of a receiver for radio, television and/or data signals which individual station list comprises a ranking of stations according to personal preferences wherein the number or duration of selections of tuned stations are detected and evaluated for determining and/or changing the ranking of the stations within the station list, **characterized in that** said individual station list is used for correlating selecting means of a control unit of said receiver to stations, thereby allowing the selection of a station by using a number in accordance with the ranking of the station within said station list and **in that** the number and duration of selections of tuned stations are detected and evaluated for determining and/or changing the ranking of the stations within the station list.

2. Method according to claim 1, **characterised in that** only those selections of a station are evaluated after which the tuned station remains tuned for a predetermined minimum duration.

3. Method according to claim 1 or 2, **characterised in that** an user identification is input to the receiver and that a station list is generated specific to the identified user.

4. Method according to claim 3, **characterised in that** different station lists are generated for different users.

5. Method according to one of the claims 1 to 4, **characterised in that** a change of the station list becomes effective only upon a manually initiated change signal.

6. Receiver for radio, television and/or data signals transmitted from several transmitting stations, comprising a memory unit including a micro controller for storing said stations ranked according to user's preferences in a station list wherein the microcontroller is arranged to receive signals corresponding to the number or duration of selections of tuned stations and to determine and/or change the ranking of the stations within the station list, **characterized in that** said microcontroller is further adapted for correlating selecting means of a control unit of the receiver to stations in accordance with a number related to the ranking of the station within said station list, and said microcontroller is arranged to receive signals corresponding to the number and duration of selections of tuned stations and to determine and/or change the ranking of the stations within the station list based on an evaluation of said received signals.

7. Receiver according to claim 6, **characterised in that** said micro controller is arranged to further receive user identification signals and to generate station lists individually for one or more users.

8. Receiver according to claim 6 or 7, **characterised in that** a default station list is stored in said memory unit and means for resetting the receiver to said default station list is provided for.

## Patentansprüche

1. Verfahren zur Erzeugung einer individuellen Senderliste eines Empfängers von Radio-, Femseh- und/oder Datensignalen, die eine Rangfolge der Sender entsprechend persönlicher Vorlieben enthält, wobei die Anzahl oder Dauer der Auswahl von eingestellten Sendern festgestellt und zur Festlegung und/oder Änderung der Rangfolge der Sender in der Senderliste ausgewertet werden, **dadurch gekennzeichnet, dass** die individuelle Senderliste zur Zuordnung von Anwahlelementen einer Bedieneinheit des Empfängers zu Sendern zur Ermöglichung der Senderauswahl durch Benutzung einer der Rangfolge des Senders in der Senderliste entsprechenden Nummer verwendet wird und dass die Anzahl und Dauer der Anwahl eingestellter Sender festgestellt und zur Festlegung und/oder Änderung der Rangfolge der Sender in der Senderliste ausgewertet werden.

2. Verfahren nach Anspruch 1, **dadurch gekennzeichnet, dass** nur solche Einstellungen eines Senders ausgewertet werden, nach denen der eingestellte Sender für eine vorbestimmte Mindestdauer eingestellt bleibt.

3. Verfahren nach Anspruch 1 oder 2, **dadurch gekennzeichnet, dass** in den Empfänger eine Benutzeridentifizierung eingegeben wird und dass die Senderliste für einen identifizierten Benutzer spezifisch erzeugt wird.

4. Verfahren nach Anspruch 3, **dadurch gekennzeichnet, dass** für verschiedene Nutzer verschiedene Senderlisten erzeugt werden.

5. Verfahren nach einem der Ansprüche 1 bis 4, **dadurch gekennzeichnet, dass** eine Änderung der Senderliste nur aufgrund eines manuell erzeugten Änderungssignals wirksam wird.

6. Empfänger für Radio-, Femseh- und/oder Datensignale, die von verschiedenen Sendern ausgesandt werden, mit einer Speichereinheit, die einen Mikrocontroller zur Speicherung der Sender in einer Senderliste in einer den Vorlieben eines Nutzers entsprechenden Rangfolge aufweist, wobei der Mikrocontroller zum Empfang von der Anzahl oder Dauer von Auswahlaktionen eingestellter Sender entsprechender Signale und zur Bestimmung und/oder Änderung der Rangfolge der Sender in der Senderliste eingerichtet ist, **dadurch gekennzeichnet, dass** der Mikrocontroller femer zur Zuordnung von Auswahlelementen einer Bedieneinheit des Empfängers zu Sendern entsprechend einer der Rangfolge des Senders in der Senderliste entsprechenden Nummer und weiterhin zum Empfang von der Anzahl und Dauer von Auswahlaktionen eingestellter Sender und zur Bestimmung und/oder Änderung der Rangfolge der Sender in der Senderliste aufgrund der Auswertung der empfangenen Signale eingerichtet ist.

7. Empfänger nach Anspruch 6, **dadurch gekennzeichnet, dass** der Mikrocontroller ferner zum Empfang von Identifikationssignalen und zur Erzeugung von Senderlisten individuell für einen oder mehrere Nutzer eingerichtet ist.

8. Empfänger nach Anspruch 6 oder 7, **dadurch gekennzeichnet, dass** eine vorausgewählte Senderliste in der Speichereinheit abgespeichert ist und dass Mittel zur Rücksetzung des Empfängers auf die vorausgewählte Senderliste vorgesehen sind.

## Revendications

1. Procédé de génération d'une liste de stations individuelles d'un récepteur pour radio, télévision et/ou signaux de données, cette liste de stations individuelles comprenant un classement de stations selon des préférences personnelles dans lequel le nombre ou la durée des sélections de stations accordées sont détectés et évalués pour déterminer et/ou modifier le classement des stations dans la liste des stations, **caractérisé en ce que** cette liste de stations individuelles est utilisée pour corréler des moyens de sélection d'une unité de commande du récepteur vers des stations, de façon à permettre la sélection d'une station en utilisant un nombre en correspondance avec le classement de la station dans la liste de stations et **en ce que** le nombre et la durée des sélections de stations accordées sont détectés et évalués pour déterminer et/ou modifier le classement des stations dans la liste de stations.

2. Procédé selon la revendication 1, **caractérisé en ce que** seulement lesdites sélections d'une station sont évaluées après qu'une station accordée reste accordée pendant une durée minimale prédéterminée.

3. Procédé selon la revendication 1 ou 2, **caractérisé en ce qu'**une identification d'un utilisateur est entrée dans un récepteur et qu'une liste de stations est générée spécifiquement pour l'utilisateur identifié,

4. Procédé selon la revendication 3, **caractérisé en ce que** des listes différentes de stations sont générées pour des utilisateurs différents.

5. Procédé selon l'une des revendications 1 à 4, **caractérisé en ce qu'**un changement de la liste de stations devient effectif seulement après un changement de signal initié manuellement.

6. Récepteur pour radio, télévision et/ou signaux de données transmis de plusieurs stations de transmission, comprenant un microcontrôleur pour stocker lesdites stations de façon classifiées dans une liste de stations selon les préférences d'un utilisateur, dans lequel le microcontrôleur est adapté pour recevoir des signaux correspondant au nombre et à la durée des sélections de stations accordées et pour déterminer et/ou modifier le classement des stations dans la liste des stations, **caractérisé en ce que** le microcontrôleur est en outre adapté pour corréler des moyens de sélection d'une unité de contrôle du récepteur vers les stations, en correspondance avec un nombre se référant avec le classement de la station dans la liste de stations, et ledit microcontrôleur est adapté pour recevoir des signaux correspondant au nombre et à la durée des sélections pour déterminer et/ou modifier le classement des stations à partir d'une évaluation des signaux reçus.

7. Récepteur selon la revendication 6, **caractérisé en ce que** le microcontrôleur est adapté en outre pour recevoir des signaux d'identification d'utilisateurs et pour générer des listes de stations individuellement pour un ou plusieurs utilisateurs.

8. Récepteur selon la revendication 6 ou 7, **caractérisé en ce qu'**une liste présélectionnée de stations est stockée dans ladite unité de mémoire et des moyens sont prévus à cet effet pour re régler le récepteur par rapport à cette liste présélectionnée de stations.
